# EUROPEAN PATENT SPECIFICATION

(11) **EP 0 710 991 B1**
(45) Date of publication and mention of the grant of the patent: **24.03.1999**
(21) Application number: 95117330.1
(22) Date of filing: 03.11.1995
(51) Int. Cl.: H01L 31/048, H01L 31/05

(54) **Group of solar cell elements, and solar cell module and production method thereof**
Gruppe von Solarzellen, Solarzellenmodul und Herstellungsverfahren
Ensemble de cellules solaires, module de cellules solaires et procédé de fabrication

(30) Priority: 04.11.1994 JP 271627/94
(43) Date of publication of application: 08.05.1996
(73) Proprietor: CANON KABUSHIKI KAISHA, Tokyo (JP)
(72) Inventor: Tsuzuki, Koji, c/o Canon K.K., Ohta-ku, Tokyo 146 (JP); Inoue, Katsuhiko, c/o Canon K.K., Ohta-ku, Tokyo 146 (JP); Takada, Takeshi, c/o Canon K.K., Ohta-ku, Tokyo 146 (JP); Takeyama, Yoshifumi, c/o Canon K.K., Ohta-ku, Tokyo 146 (JP)
(74) Representative: Tiedtke, Harro, Dipl.-Ing.

(56) References cited:
- EP-A- 0 048 830
- DE-A- 4 104 713
- PATENT ABSTRACTS OF JAPAN vol. 012 no. 013 (E-573) ,14 January 1988 & JP-A-62 173768 (SHARP CORP) 30 July 1987,

## Description

### BACKGROUND OF THE INVENTION

### Field of the Invention

The present invention concerns a group of solar cell elements, and a solar cell module and a production method thereof. More particularly, the invention relates to a group of solar cell elements, wherein strips of insulating tape are stuck in parallel with metal foil members on and across back faces of solar cell elements arranged next to each other, and to a solar cell module and a production method thereof.

### Related Background Art

The thermal power generation, which has been a major source of power supply heretofore, includes problems in terms of prevention of global warming. Therefore, recent demands are to attain an energy source with a less amount of CO₂ emission. On the other hand it is pointed out that the nuclear power generation without emission of CO₂ involves significant environmental pollution due to radioactive substances. From these aspects, quick development is being demanded of a nonpolluting and safety energy source.

Among prospective clean energy sources, particularly, solar cells are drawing much attention in terms of their cleanness, safety, and easiness of handling.

Among various solar cells, an amorphous silicon solar cell is inferior in conversion efficiency to crystal silicon solar cells, but has excellent features that cannot be expected with the crystal silicon solar cells, for example easiness to construct a large-area cell and capability of operating in a thin film because of a large optical absorption coefficient, and is one of promising solar cells.

Normally, battery-ready solar cells often use a plurality of solar cell elements connected in series, because a single solar cell element cannot supply a sufficient output voltage. Further, parallel connection of solar cell elements with each other is employed in order to increase an amount of electric current, and there are some cases to employ the both series connection and parallel connection.

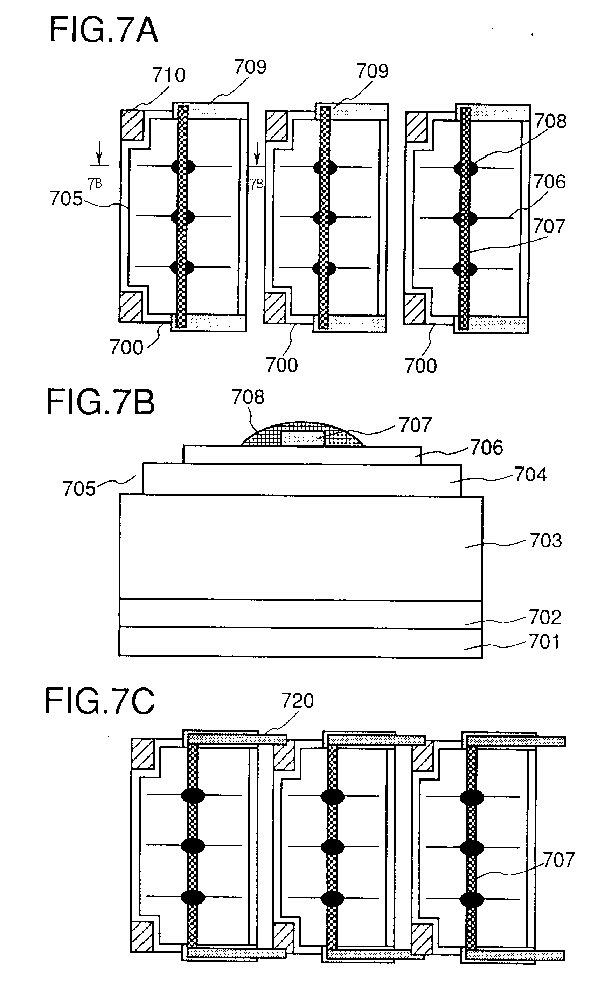

Figs. 7A-7C are schematic drawings of series connection in a conventional solar cell module. Fig. 7A shows a state before series connection and Fig. 7C a state after series connection. Further, Fig. 7B is a cross section along 7B-7B in Fig. 7A.

In Figs. 7A-7C, reference numeral 700 designates solar cell elements, in each of which a lower electrode layer 702, a semiconductor layer 703, and an upper electrode layer 704 are formed in the stated order on a substrate 701.

Each of these solar cell elements 700 is arranged so that parts (705) of the upper electrode layer 704 are removed in order to achieve perfect electrical separation between the upper electrode 704 and the lower electrode 702, thereafter a collector electrode 706, which is a collecting electrode of the upper electrode 704, is formed, then a bus-bar electrode 707, which is a further collecting electrode of the collector electrode 706, is mounted on the collector electrode 706, and the collector electrode 706 and bus-bar electrode 707 are electrically connected with each other with a conductive adhesive 708, thus obtaining a lead electrode from the upper electrode 704.

In order to make electrical separation sure between the bus-bar electrode 707 and the substrate 701, insulating tape 709 is provided between the ends of a solar cell element 700 and a bus-bar electrode 707. Strips of insulating tapes 709 are stuck so as to cover places (particularly, edge portions at the ends of elements) where series connection members to be connected to the bus-bar electrodes 707 later on could come to touch the lower electrodes 702, thereby ensuring the electric separation.

Next, electrical routing from the lower electrodes 702 is achieved as follows. For later series connection, portions 710 are formed as being exposed by a mechanical method at portions of the conductive substrate 701 in each solar cell element 700. After that, connecting members 720 each are placed, as shown in Fig. 7C, so as to overlap with the bus-bar electrode 707 of a solar cell element 700 and the exposed portions 710 of the lower electrode of an adjacent solar cell element 700, and overlapping portions are connected in series by soldering.

Finally, a group of solar cell elements 700 thus connected in series are sealed with a filler material of ethylene-vinyl acetate (EVA) as a protection material, thus completing a solar cell module.

However, solar cell modules require great care in handling, for example when more than ten solar cell elements are connected in series therein, though no trouble will be caused in the case of a solar cell module with three-serial cells as in the conventional example illustrated, i.e., the module in which three solar cell elements are connected in series.

In more detail, when an element group is moved to a line of next step after completion of series connection or when the element group is turned over for leading final terminals out from the back face, most stress is loaded on the connecting members 720 upon handling the element group, resulting in the following problems.
(1) Since the connecting members 720 are firmly connected to the bus-bar electrodes 707, the stress is transferred to the bus-bar electrodes 707. If the stress should become over a fixing force of the conductive adhesive 708, a bus-bar electrode 707 would be peeled off from the solar cell element.
(2) The stress could bend a connecting member 720 and form a crease in the connecting member 720. As a result, when repeated bending stress is imposed on the solar cell module, the stress is concentrated on the crease portion, which will be broken soon or later.

If the connecting members 720 were made of a strong material that can stand the stress, they could be free of the above-described problems. However, the connecting members 720 will have a shape with some thickness in this case. This raises another problem that bubbles are formed in step portions of the connecting members when the solar cell elements 700 are sealed with a filler material later on.

### SUMMARY OF THE INVENTION

An object of the present invention is to provide a group of solar cell elements and a solar cell module low in cost, easy in work, and high in reliability, and a production method thereof, overcoming the above problems.

A group of solar cell elements according to the present invention is a group of solar cell elements formed of a plurality of solar cell elements connected in series or in parallel by metal foil members, wherein an insulating tape is fixed on and across the back faces of the plurality of solar cell elements arranged next to each other, said insulating tape being parallel to said metal foil members.

The group of solar cell elements according to the present invention is characterized in that the insulating tape comprises a base material of either one resin selected from polyethylene terephthalate (PET), polycarbonate, and polypropylene.

Further, a solar cell module according to the present invention is characterized in that the group of solar cell elements is covered with a polymeric organic resin.

Further, a method for producing a solar cell module according to the present invention is a production method of the solar cell module, which comprises a step of arranging a plurality of solar cell elements, a step of sticking an insulating tape on the plurality of solar cell elements, a step of connecting the plurality of solar cell elements in series or in parallel by metal foil members, and a step of covering the solar cell elements with a polymeric organic resin.

### BRIEF DESCRIPTION OF THE DRAWINGS

Figs. 1A, 1B, and 1C are schematic drawings of a group of solar cell elements according to Example 1;
Figs. 2A and 2B are schematic drawings to show a function of the connecting members of the present invention;
Fig. 3 is a schematic drawing to show a basic structure of a polymeric organic resin according to the present invention;
Fig. 4 is a schematic drawing of a solar cell element according to the present invention;
Fig. 5 is a graph to show relations between number of repeated bending cycles and conversion efficiency in solar cell modules according to Example 2 and Comparative Example 2;
Figs. 6A to 6C are schematic drawings of a solar cell module according to Example 3; and
Figs. 7A to 7C are schematic drawings of a solar cell module and solar cell elements according to a conventional example.

### DETAILED DESCRIPTION OF THE PREFERRED EMBODIMENTS

The embodiments of the present invention will be explained.

### (Group of solar cell elements)

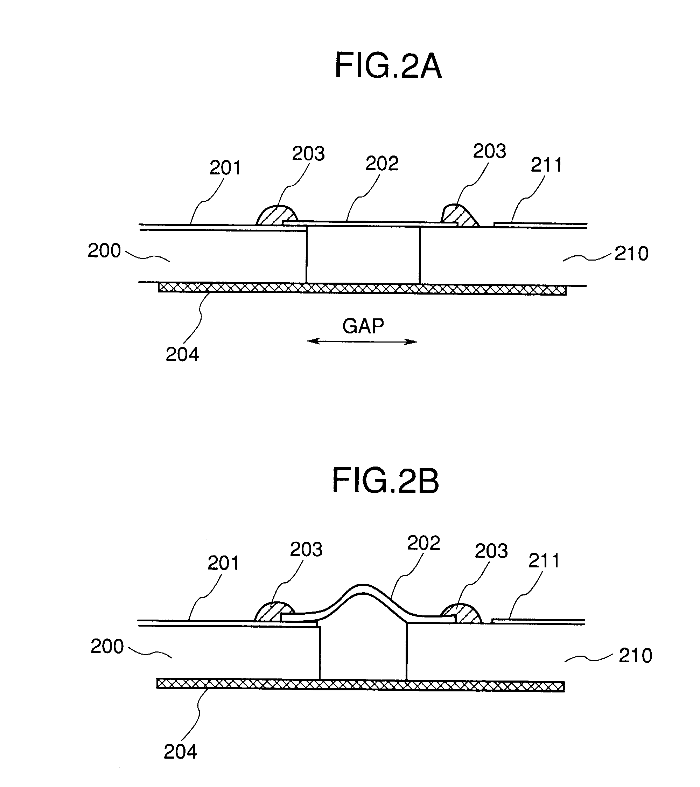

An example of a group of solar cell elements used in the present invention is the one shown in Figs. 2A and 2B. Figs. 2A and 2B show two solar cell elements adjacent to each other, connected by connecting members. Fig. 2A shows a state before lamination and Fig. 2B a state after lamination.

In Fig. 2A, solar cell elements 200 and 210 are placed with a suitable gap inbetween, and a collector electrode (upper electrode) 201 of solar cell element 200 is connected in series with the substrate side (lower electrode) of adjacent solar cell element 210 by connecting member 202 through solder 203. Insulating tape 204 is stuck on and across the back faces of the two solar cell elements. In this state, the connecting member 202 take a linear shape.

A solar cell module used in the present invention means one in which a group of solar cell elements as described above is covered with a polymeric organic resin. A specific example of a method for producing the solar cell module is one comprising putting a film of a polymeric organic resin over the entire group of solar cell elements (not shown) and heat-pressing them by a conventionally known method such as vacuum lamination. This method causes heat shrinkage of the insulating tape on the back faces, as shown in Fig. 2B, so as to narrow the gap and deform the connecting member 202 into a loop shape. This loop functions as a stress loop for relaxing various stresses such as tensile, compressive, and bending stresses, mainly loaded on the connecting member 202 in the solar cell module, which is very effective to improving mechanical reliability of solar cell module.

### (Metal member)

A metal member for the connecting member 202 of the solar cell module used in the present invention may be a metal, for example silver, copper, tin, zinc, or nickel, etc., taking account of three points of (1) good electrical conductivity, (2) feasibility of soldering, and (3) easiness of processing. However, without having to be limited to these, the metal member may be a metal foil member with a coat on the surface, for example such as silver plating copper or silver cladding copper. The thickness is preferably determined as thick as possible, considering the mechanical strength and the fact that the connecting members are portions through which an electric current flows, but as thin as possible on the other hand from a demand to decrease the thickness of the lamination. From a trade-off between the both, a specific range of the thickness is preferably between 70 and 200 µm.

### (Insulating tape)

A variety of materials can be used without any specific restriction for the insulating tape 204 employed in the present invention: for example, acryl, urethane, polyester, polyimide, vinyl chloride, silicone, fluorine, polyethylene, polypropylene, and glass cloth tapes, etc. However, taking account of the following two points: (1) use of a hard base material is preferable in order to more decrease the stress exerted on the connecting members 202; (2) the tape needs to have long-term reliability in respect of the fact that it is a packaging portion of solar cell, polyethylene terephthalate (PET) and polycarbonate are particularly preferred among the various resins.

### (Polymeric organic resin)

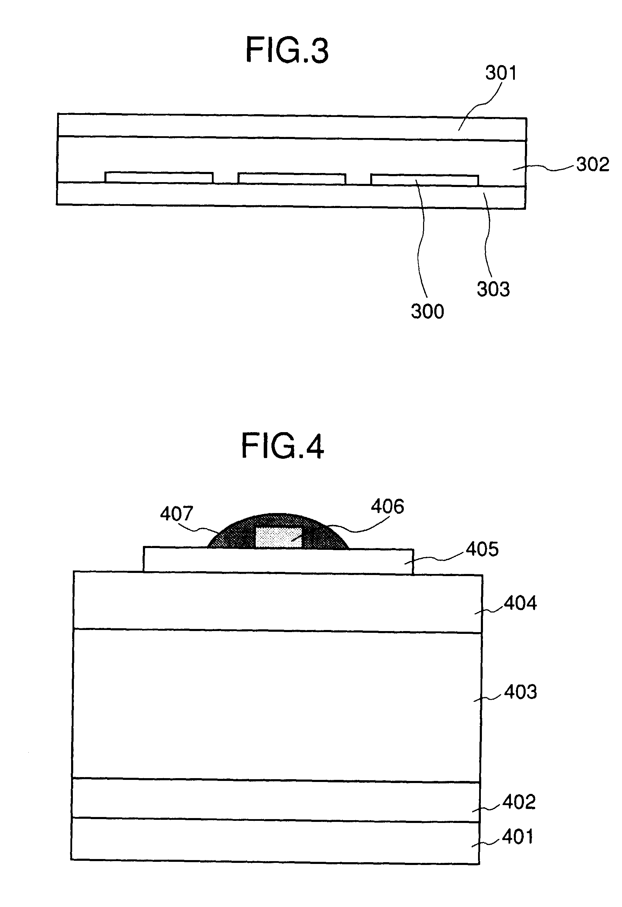

The polymeric organic resin used in the present invention is, for example, the one shown in Fig. 3. The polymeric organic resin of Fig. 3 includes a topmost material 301, a top sealant 302, and a bottom sealant 303.

### (Top sealant)

The top sealant 302 used in the present invention is necessary for covering projections of solar cell elements with a resin, protecting the elements from the hard external environment including temperature change, humidity, and impact, and securing connection between the topmost material 301 and the elements 300. Accordingly, required properties of the top sealant include weather resistance, adhesive property, filling property, heat resistance, freeze resistance, and impact resistance. Resins to meet these requirements are, for example, polyolefin resins such as ethylene-vinyl acetate copolymers (EVA), ethylene-methyl acrylate copolymers (EMA), ethylene-ethyl acrylate copolymers (EEA), and polyvinyl butyral resins, urethane resins, silicone resins, fluorine resins, etc. Among them, EVA can be preferably used because of possession of balanced physical properties for applications in solar cell. However, EVA without treatment has a low heat deformation temperature and will be easily deformed or crept under the use at high temperatures. Thus, it is preferably crosslinked to raise the heat resistance.

### (Topmost material)

Since the topmost material 301 employed in the present invention is located as an outermost layer of the solar cell module, it needs to have not only properties of weather resistance, stain resistance, and mechanical strength, but also properties for securing long-term reliability in outdoor exposure of solar cell module. Examples of materials suitably applicable in the present invention are fluorine resins and acryl resins. Particularly, the fluorine resins can be preferably used because of excellent weather resistance and stain resistance thereof. More specifically, the fluorine resins include polyvinylidene fluoride resins, polyvinyl fluoride resins, and ethylene tetrafluorideethylene copolymers. Among them, the polyvinylidene fluoride resins are excellent in respect of weather resistance. Particularly, the ethylene tetrafluorideethylene copolymers are most excellent because they have excellent weather resistance and mechanical strength, and transparency.

The topmost material 301 does not have to be limited to the resins. For example, there occurs no trouble when a glass or the like is used for the topmost material.

### (Bottom sealant).

Preferred materials for the bottom sealant 303 used in the present invention are those that can secure sufficient adhesivity to the substrate and that are excellent in long-term durability. Suitably applicable materials include hot-melt materials such as EVA and polyvinyl butyral, double-sided tapes, and epoxy adhesives with flexibility. A reinforcing sheet may be adhered to the outside of the bottom sealant 303 in order to increase the mechanical strength of solar cell module or in order to prevent strain and warpage due to a temperature change. Preferred examples of the reinforcing sheet are a steel plate, a plastic plate, and an FRP (glass-fiber-reinforced plastic) plate.

### (Method of heat pressing)

The method of heat pressing employed in the present invention can be selected from a variety of conventionally known methods, for example vacuum lamination, roll lamination, etc.

### (Solar cell elements)

The solar cell elements (see Fig. 4) used in the present invention can be applied to single crystal, polycrystal, or amorphous silicon solar cells, and can also be applied to solar cells using semiconductors other than silicon, and solar cells of a Schottky junction type. However, the following description concerns a representative example of amorphous silicon solar cell.

### (Substrate)

The substrate 401 used in the present invention is a member for mechanically supporting the semiconductor layer in the case of the thin-film type solar cell of amorphous silicon. Further, since the substrate is used also as an electrode in some cases, the substrate is demanded to have heat resistance to stand a heating temperature upon film-forming the semiconductor layer 403. The substrate may be electrically conductive one or electrically insulating one.

Specific examples of the conductive material include thin plates of metals such as Fe, Ni, Cr, Al, Mo, Au, Nb, Ta, V, Ti, Pt, and Pb or alloys thereof, for example brass or stainless steel, and composites thereof, carbon sheet, and galvanized sheet iron.

Further, specific examples of the electrically insulating material include films or sheets of heat-resistant synthetic resins such as polyethylene, polycarbonate, cellulose acetate, polypropylene, polyvinyl chloride, polyvinylidene chloride, polystyrene, polyamide, polyimide, and epoxy, or composites of those with glass fiber, carbon fiber, boron fiber, or metal fiber, those obtained by performing a surface coating treatment by sputtering, vapor deposition, plating, or the like of a metal conductive film of a different material and/or an insulating thin film of SiO₂, Si₃N₄, Al₂O₃, or AlN on the surface of a thin film of one out of the metals, a resin sheet, or the like, and glasses, ceramics, etc.

### (Lower electrode)

The lower electrode 402 used in the present invention is one electrode for taking the power generated in the semiconductor layer out, and needs to be of a material having a work function to become an ohmic contact for the semiconductor layer. Specific examples of the material for the lower electrode include so-called metals themselves or alloys thereof, such as Al, Ag, Pt, Au, Ni, Ti, Mo, Fe, V, Cr, Cu, stainless steel, brass, nichrome, SnO₂, In₂O₃, ZnO, and ITO, and transparent conductive oxides (TCO), etc.

The surface of the lower electrode 402 is preferably flat, but may be texturized in order to cause diffused reflection of light. If the substrate 401 is electrically conductive, the lower electrode 402 does not have to be provided in particular.

The method for fabricating the lower electrode may be either one of plating, vapor deposition, sputtering, etc.

### (Semiconductor layer)

The semiconductor layer 403 used in the present invention can be of one of known semiconductor materials normally used in thin-film solar cells. The semiconductor layer 403 in the solar cell element used in the present invention may be, for example, a pin junction amorphous silicon layer, a pn junction polycrystal silicon layer, or a compound semiconductor layer such as CuInSe₂/CdS.

In the case of the amorphous silicon layer, the method for forming the semiconductor layer 403 may be, for example, plasma CVD for generating plasma discharge in a starting gas for forming a film, such as silane gas. In the case of the pn junction polycrystal silicon layer, the semiconductor layer is formed by a film forming method for forming a film, for example, from fused silicon. In the case of CuInSe₂/CdS, the semiconductor layer is formed by either one of electron beam evaporation, sputtering, electrodeposition, etc.

### (Upper electrode)

The upper electrode 404 used in the present invention is an electrode for taking an electromotive force generated in the semiconductor layer out, which is paired with the lower electrode 402. The upper electrode 404 becomes necessary when the semiconductor has high sheet resistance like amorphous silicon, but is not necessary particularly for crystal solar cells because they have low sheet resistance. Since the upper electrode 404 is located on the light entrance side, it must be transparent. Thus, the upper electrode 404 is also called as a transparent electrode. The upper electrode 404 preferably has a transmittance of light of at least 85 % for effective absorption of light from the sun or a white fluorescent tube or the like in the semiconductor layer. Further, from the electrical point, the upper electrode preferably has the sheet resistance of not more than 100 Ω/□ in order to let an electric current generated by the light flow in the lateral direction with respect to the semiconductor layer. Materials provided with such characteristics are metal oxides such as SnO₂, In₂O₃, ZnO, CdO, CdSnO₄, and ITO (In₂O₃ + SnO₂).

### (Collector electrode)

The collector electrode 405 used in the present invention is normally formed in a comb shape, and suitable width and pitch thereof are determined from the values of sheet resistance of the semiconductor layer 403 and upper electrode 404. The collector electrode 405 is demanded to have a low electrical resistivity and not to become a series resistor of solar cell. A preferred electrical resistivity is in the range of 10⁻² Ωcm to 10⁻⁶ Ωcm. The material for the collector electrode 405 may be selected, for example, from metals such as Ti, Cr, Mo, W, Al, Ag, Ni, Cu, Sn, and Pt, or alloys thereof or solders. Generally, a metal paste in which metal powder and a polymer binder are present in the paste form is used, but the material for the collector electrode is by no means limited to it.

### (Bus-bar electrode)

The bus-bar electrode 406 used in the present invention is an electrode for collecting an electric current flowing in the collector electrode 405 to one end thereof. The material for the bus-bar electrode 406 may be selected from for example, metals such as Ag, Pt, and Cu, and alloys thereof. The bus-bar electrode is formed by adhering a wire shape or a foil shape of the material to the collector electrode. The foil is, for example, a copper foil or a tin-plated copper foil, which may be used with an adhesive in some cases. As for the place of the bus-bar electrode located, the bus-bar electrode does not have to be located in the center of solar cell element, but may be located in the periphery of solar cell element.

### Examples

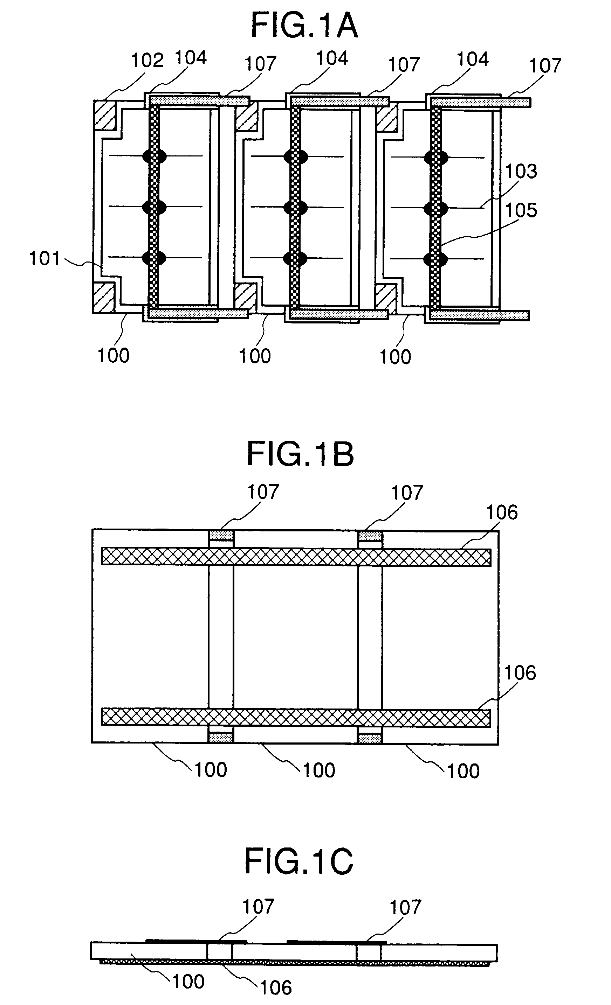

Examples of the present invention will be explained referring to Figs. 1A-1C to Figs. 6A-6C.

### (Example 1)

This example shows an amorphous silicon solar cell using a stainless steel substrate as the substrate, which will be explained in detail referring to Figs. 1A-1C. Fig. 1A is a schematic drawing of solar cell elements as a view from the light entrance surface side, Fig. 1B a schematic drawing of the solar cell elements as a view from the back surface side, and Fig. 1C a schematic drawing of the solar cell elements as a view from the side.

First prepared as a substrate for solar cell elements was a rolled stainless steel substrate made of a stainless steel foil having the thickness of 0.1 mm with cleaned surfaces.

Next, a plurality of solar cell elements 100 were simultaneously formed on the surface of the stainless steel substrate. A solar cell element 100 was of a structure including multilayered films as listed in Table 1.

**TABLE 1**

| Name/Thickness | Base surface | Forming method/Temp. | Material(s) used |
|---|---|---|---|
| Stainless steel substrate/0.1 mm | -- | --/ | |
| ZnO film/500 nm | Stainless steel substrate | sputtering/350 °C | ZnO |
| n-type a-Si layer/15 nm | ZnO film | P-CVD/250 °C | SiH₄, PH₃, H₂ |
| i-type a-Si layer/400 nm | n-type a-Si layer | P-CVD/250 °C | SiH₄, H₂ |
| p-type a-Si layer/10 nm | i-type a-Si layer | P-CVD/250 °C | SiH₄, BF₃, H₂ |
| ITO layer/70 nm | p-type a-Si layer | Vapor deposition/200 °C | In, Sn, O₂ |

The rolled stainless steel substrate with the above layers was then cut to produce ten solar cell elements 100 shown in Fig. 1A (which shows only three of them).

The solar cell elements 100 were then subjected to the following processes, thereby producing a group of solar cell elements A.
(1) A paste containing an etchant (FeCl₃) for ITO was printed by screen printing in the pattern of 101 on the surface of each solar cell element 100, and thereafter the element was washed with pure water to remove a part of the ITO layer, thereby making electrical separation sure between the upper electrode and the lower electrode.
(2) Each solar cell element 100 was ground by a grinder to remove the ITO layer, the a-Si layers, and the lower electrode layer from a part of the non-effective power generation area and to expose the surface of stainless steel substrate 102, thereby forming lead-out portions from the lower electrode portion.
(3) The collector electrode 103 was formed in the thickness of 0.3 mm on ITO by printing a silver paste on ITO by screen printing and baking it in an oven.
(4) In order to make electrical insulation sure between the bus-bar electrode 105 as described below and the lower electrode, a polyimide insulating tape (of the thickness of 100 µm) 104 was stuck on portions adjacent to the exposed surfaces of substrate.
(5) The individual solar cell elements were turned over, so that the ten solar cell elements were arranged at equal intervals with a gap of 1 mm between them. After that, as shown in Fig. 1B, two strips of polyethylene terephthalate (PET) tape 106 having the thickness of 100 µm were stuck on and across the all ten elements in the series direction of elements.
(6) Then the element group, on which the tape was stuck, was turned over, and then connecting members 107 were produced by blanking of a copper foil of the thickness 100 µm. The connecting members thus produced were placed as shown in Fig. 1A, and thereafter soldering was carried out for each member at an intersecting portion with the bus-bar electrode 105 and an intersecting portion with the exposed portion of the lower electrode 102 of an adjacent element to effect electrical connection between them.

As described above, the insulating tape 106 was stuck on the solar cell elements 100 before series connection thereof so as to fix the elements, whereby the elements were able to be connected with good working efficiency and accuracy without deviation of elements upon serial connection. After completion of these sequential works, the group of solar cell elements needs to be turned over in order to route the final terminals to the back side. Since the element group was fixed by the PET tape stuck thereon, the group was able to be easily turned over without bending or deformation of the metal foil members and without contact between the elements.

The provision of the insulating tape 106 on the back faces as described above can facilitate handling and can improve the yield in producing solar cells.

### (Comparative Example 1)

This example is different from Example 1 only in that a group of solar cell elements B was produced without sticking the insulating tape 106 of PET thereon.

The other points were the same as in Example 1.

Since this example was arranged so that the positions of elements were not fixed upon connection by the series connecting members, different from Example 1, a considerable time was required for connecting the elements with an accurate gap of 1 mm between them.

After completion of series connection between solar cell elements, turning operation of the elements was carried out in order to attach final lead-out terminals thereto. During the operation of series connection between ten elements (where ten solar cell elements were connected in series), the metal members near the center were bent, which extremely lowered flatness of the group of solar cell elements. Further, when the group was again turned front after completion of leading-out of final terminals, a phenomenon that the bus-bar electrode 105 was peeled off from the element was frequently observed in the elements near the center.

As explained above, it was found that the yield was largely lowered in the actual steps in the case without the insulating tape 106.

### (Example 2)

In this example, the group of solar cell elements A in Example 1 was covered with an EVA sheet etc. to produce a solar cell module A. The following describes the method of covering.
(1) On the light-receiving surface side of the solar cell element group: on the light-receiving surface there were layered in order (i) an EVA sheet (available as a trade name of Photocap and in the thickness of 460 µm from Springborn Laboratories Inc.); and (ii) an uniaxial oriented ETFE film one surface of which was subjected to a corona discharge treatment (available as a trade name of Tefsel T2 film and in the thickness of 38 µm from Dupont Inc.).
(2) On the non-light-receiving surface side of the solar cell element group: on the surface of the back face opposite to the light-receiving surface there were layered in order (i) an EVA sheet (available as a trade name of Photocap and in the thickness of 460 µm from Springborn Laboratories Inc.); (ii) a nylon film (available as a trade name of Durtec and in the thickness of 63.5 µm from Dupont Inc.); and (iii) Galvalume with black coating (galvanized iron sheet, thickness 0.27 mm).
(3) From the above steps (1) and (2), a laminate was formed in a structure of ETFE/EVA/solar cell element group/EVA/nylon/EVA/iron sheet, and thereafter this laminate was heated at 150 °C for 30 minutes with evacuation under pressure using a vacuum laminate apparatus, thereby obtaining a solar cell module C.

The EVA sheet used herein was one widely used as a sealant of solar cell, in which 1.5 parts by weight of a crosslinking agent, 0.3 part by weight of an ultraviolet absorber, 0.1 part by weight of a light stabilizer, 0.2 part by weight of an anti-oxidant, and 0.25 part by weight of a silane coupling agent were blended to 100 parts by weight of an EVA resin (wherein the content of vinyl acetate was 33 %).

The output terminals were preliminarily routed to the back side of the photovoltaic elements, and after lamination, outputs were arranged to be taken out through terminal leading-out ports preliminarily formed in the Galvalume, thus producing a solar cell module.

The other points were the same as in Example 1.

Appearance of the solar cell module A of this example was inspected, and it was found that the gaps between elements set at 1 mm were measured to be about 0.7 mm. It was also observed that there were fine rises of the surface near the series members. From this it was presumed that the PET tape contracted because of the heat upon lamination to narrow the gaps between the elements and to form loops in the series members.

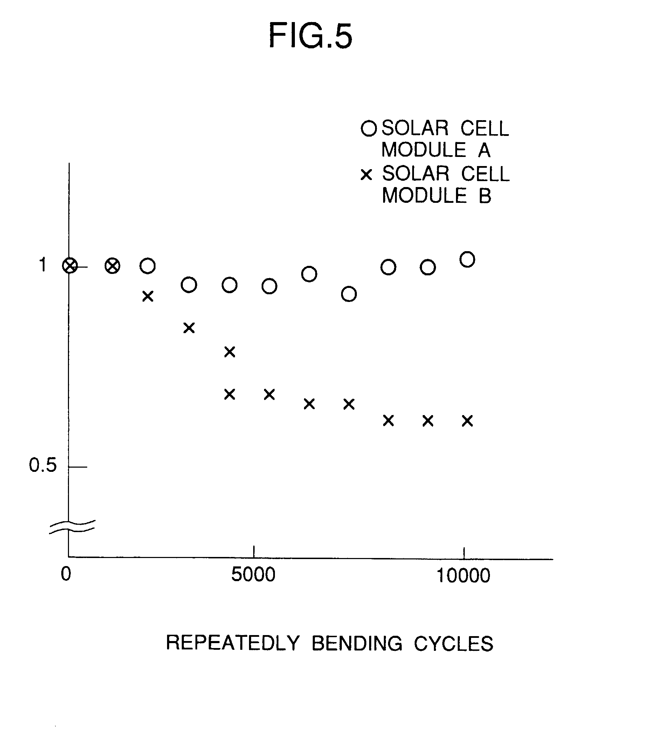

The solar cell module A in this example was subjected to a test of repeated bending cycles. The test of repeated bending cycles conducted is a withstand load test according to SERI standard, and the test included 10000 cycles. During the test, inspection of appearance and check of conversion efficiency were performed every 1000 cycles. Fig. 5 is a graph to show relations between conversion efficiency and repeated bending cycles. The ordinate represents the conversion efficiency, as normalized by a numerical value before the test of repeated bending cycles. The test results showed that the solar cell module A of the present example had little change in appearance and conversion efficiency after 10000 cycles.

### (Comparative Example 2)

This example is different from Example 2 only in that the group of solar cell elements B in Comparative Example 1 was covered with the EVA sheet etc., thus producing a solar cell module B.

The other points were the same as in Example 2.

Appearance of the solar cell module B of this example was inspected. There was no change in the gaps between the elements, which had been set to 1 mm, and there was no rise of the surface observed near the series members where the rises were observed in Example 2 (solar cell module A).

The solar cell module B of this example was also subjected to the same test of repeated bending cycles as in Example 2. The test results showed that the solar cell module B of this example started decreasing the conversion efficiency at 2000 cycles. A drop of about 30 % of the initial value was observed at about 4000 cycles, and in addition cracks were visually recognized in the series members near the center.

Accordingly, the results of Example 2 and Comparative Example 2 confirmed that the series members formed stress loops through adhesion of the insulating tape on the back surface and the covering step with the polymeric organic resin and that the loops functioned as loops for relaxing stress against bending of solar cell module.

### (Example 3)

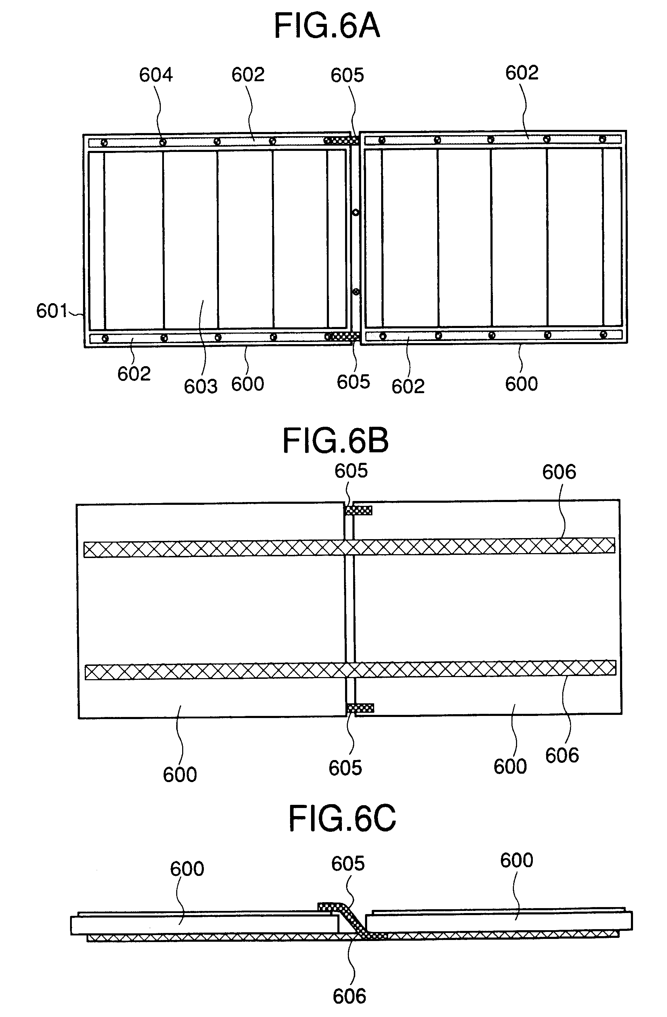

In this example, the collector electrodes made of the silver paste in Example 1 were replaced by copper wires, thereby producing a group of solar cell elements C. Next explained referring to Figs. 6A-6C is a method for producing the group of solar cell elements C according to the present invention. Here, a solar cell element 600 shown in Figs. 6A-6C has exactly the same multilayered films as the solar cell element 100 in Example 1 had. Although the drawings show only two solar cell elements, five elements were actually prepared.
(a) A paste containing an etchant (FeCl₃) for ITO was printed in the pattern of 601 by screen printing on the surface of each solar cell element 600, and thereafter it was washed with pure water to remove parts of the ITO layer, thereby making electrical separation sure between the upper electrode and the lower electrode.
(b) A polyimide insulating tape of the thickness 70 µm was stuck on immediately outside the etching region (not shown), and a copper foil 602 of the thickness 100 µm was further stuck through a double-sided tape on the insulating tape. At this stage the copper foil 602 is in an electrically floating state.
(c) A copper wire having a diameter of 100 µm was coated with a carbon paste commercially available, in the thickness of 20 µm, and thereafter the coating was dried to prepare a carbon coated wire. This wire was placed as shown in Fig. 6A and was pressed at 150 °C for 20 seconds as applying the pressure of one atmospheric pressure so as to be bonded to an effective region of a solar cell element, thereby forming the collector electrode 603.
(d) Further, in order to make electrical connection sure between the copper foil 602 and the collector electrode 603, a silver paste was applied in spot patterns (604) onto the surface of the collector electrode 603 on the copper foil 602, and then was hardened in an oven. This enabled the copper foil 602 to become a lead-out electrode from the upper electrode.
(e) After that, rectangular metal foil members 605, which were produced by blanking a copper foil of the thickness 100 µm with a die, were connected by soldering to the right ends of the copper foils 602, as shown in Fig. 6A.
(f) Five solar cell elements produced by the above steps (a) to (e) were placed top downward with a gap of 1 mm between elements, and two strips of PET tape were stuck thereon as shown in Fig. 6B. After the group of elements was perfectly fixed, the elements were connected in series by soldering the connecting members 605 to the stainless steel substrate on the back face of an adjacent element.

The other points were the same as those in Example 1.

The group of solar cell elements C completed up to the above step of (f) was subjected to the final leading-out operation on the back side, and with turning the element group over twice, the connecting members 605 had no bending at all and the operation was smoothly completed.

Further, the group of these solar cell elements C was covered exactly in the same manner as in Example 2, thus producing a solar cell module C with five series elements (where five solar cell elements were connected in series). From inspection of appearance, it was confirmed that the gaps having been set to 1 mm were narrowed to about 0.8 mm. Further, fine rises of the surface were observed immediately above the series connecting members.

Further, the solar cell module C was subjected to the same test of repeated bending cycles as in Example 2, which confirmed that the module had little change in appearance and conversion efficiency after 10000 cycles.

### (Comparative Example 3)

This example is different from Example 3 only in that a group of solar cell elements D was produced without adhesion of the insulating tape of PET.

The other points were the same as in Example 3.

In this example, the work of the series members took a considerable time, because the positions of the elements were not fixed, different from Example 3.

The final leading-out operation on the back side was carried out for the group of solar cell elements D after completion of series connection. After the group of elements was turned over twice, the metal members were bent just in the center out of the five series elements (where the five solar cell elements were connected in series), thus losing flatness of the solar cell element group.

Further, appearance of the solar cell module C of this example was inspected. There was no change observed in the gaps between the elements, having been set to 1 mm, and no rise of the surface was recognized near the series members, where the rises were observed in Example 3 (solar cell module C). The test of repeated bending cycles was carried out, and the conversion efficiency at 1000 cycles was lowered to about the half of the initial value. Checking appearance of the module after the test, rupture was observed in the portions which had been bent upon series connection.

Accordingly, the results of Example 3 and Comparative Example 3 confirmed that, also in the case where the series members were formed between the top and the bottom of adjacent elements, the stress loops were formed in the metal foil members because of contraction of the tape, thereby producing a module with high mechanical reliability and improving the yield.

The results as to Example 3 and Comparative Example 3 as described above were also maintained when a polyimide insulating tape of the thickness 25 µm was used instead of the PET tape.

As explained above, the present invention can improve the working efficiency and yield in producing the group of solar cell elements. Also, the present invention can provide the solar cell module with high reliability and the method for producing stable solar cell modules.

In the present invention, the insulating tape is stuck on and across the plurality of solar cell elements to be connected and the both tape and connecting members (metal foil members) can receive the stress exerted upon handling the group of solar cell elements connected, which can decrease the stress exerted on the connecting members in the conventional example.

As a result, the connecting members are rarely bent and thus, no crease is formed in the connecting members. A decrease in the stress on the connecting members can also decrease the stress transmitted to the bus-bar electrode, whereby the bus-bar electrode can be prevented from being peeled off.

Further, the insulating tape contracts because of heat upon lamination in the step of covering the group of solar cell elements with the polymeric organic resin (in the lamination step), so that the connecting members can form stress loops so as to form a strong structure against repeated bending stress.

## Claims

1. A group of solar cell elements formed of a plurality of solar cell elements (100, 200, 600) connected in series or in parallel by metal foil members (107, 202, 605), wherein an insulating tape (106, 204, 606) is fixed on and across the back faces of the plurality of solar cell elements arranged next to each other, said insulating tape being parallel to said metal foil members.

2. The group of solar cell elements according to Claim 1, wherein said insulating tape comprises a base material of either one resin selected from polyethylene terephthalate and polycarbonate.

3. A solar cell module comprising a group of solar cell elements as set forth in Claim 1 or 2 covered with a polymeric organic resin.

4. A method of producing a solar cell module according to claim 3, comprising a step of arranging a plurality of solar cell elements, a step of sticking an insulating tape on the back face of the plurality of solar cell elements, a step of connecting said plurality of solar cell elements in series or in parallel by metal foil members, and a step of covering the solar cell elements with a polymeric organic resin.

## Patentansprüche

1. Gruppe von Solarzellenelementen, die aus einer Vielzahl von durch Metallfolienteile (107, 202, 605) in Serie oder parallel verbundenen Solarzellenelementen (100, 200, 600) gebildet ist, wobei ein Isolierband (106, 204, 606) auf und über die Rückseiten der Vielzahl der nebeneinander angeordneten Solarzellenelemente befestigt ist, wobei das Isolierband parallel zu den Metallfolienteilen ist.

2. Gruppe von Solarzellenelementen nach Anspruch 1, wobei das Isolierband ein Basismaterial aus einem Harz umfaßt, das aus Polyethylen-Terephthalat und Polycarbonat ausgewählt ist.

3. Solarzellenmodul, das eine wie in Anspruch 1 oder 2 aufgeführte Gruppe von Solarzellenelementen umfaßt, die mit einem polymeren, organischen Harz bedeckt ist.

4. Verfahren zur Herstellung eines Solarzellenmoduls nach Anspruch 3, das einen Schritt des Anordnens einer Vielzahl von Solarzellenelementen, einen Schritt des Klebens eines Isolierbandes auf die Rückseite der Vielzahl von Solarzellenelementen, einen Schritt des Verbindens der Vielzahl von Solarzellenelementen in Serie oder parallel durch Metallfolienteile, und einen Schritt des Bedeckens der Solarzellenelemente mit einem polymeren, organischen Harz umfaßt.

## Revendications

1. Groupe d'éléments de cellules solaires formé d'une pluralité d'éléments (100, 200, 600) de cellules solaires connectés en série ou en parallèle par des éléments (107, 202, 605) à lame métallique, dans lequel un ruban isolant (106, 204, 606) est fixé sur, et à travers, les faces arrière de la pluralité d'éléments de cellules solaires disposés les uns à côté des autres, ledit ruban isolant étant parallèle auxdits éléments à lame métallique.

2. Groupe d'éléments de cellules solaires selon la revendication 1, dans lequel ledit ruban isolant comprend une matière de base d'une résine choisie entre du téréphtalate de polyéthylène et du polycarbonate.

3. Module de cellules solaires comportant un groupe d'éléments de cellules solaires selon la revendication 1 ou 2, recouvert d'une résine organique polymérique.

4. Procédé de production d'un module de cellules solaires selon la revendication 3, comprenant une étape d'agencement d'une pluralité d'éléments de cellules solaires, une étape de collage d'un ruban isolant sur la face arrière de la pluralité d'éléments de cellules solaires, une étape de connexion de ladite pluralité d'éléments de cellules solaires en série ou en parallèle à l'aide d'éléments à lame métallique, et une étape de recouvrement des éléments de cellules solaires par une résine organique polymérique.
